# EUROPEAN PATENT APPLICATION

(11) **EP 1 482 539 A1**
(43) Date of publication of application: **01.12.2004**
(21) Application number: 03291253.7
(22) Date of filing: 26.05.2003
(51) Int. Cl.: H01L 21/314, H01L 21/762

(54) **Preparation method for protecting the back side of a wafer and back side protected wafer**

(71) Applicant: S.O.I. Tec Silicon on Insulator Technologies S.A., 38190 Bernin (FR)
(72) Inventor: Maurice, Thibaut, 38100 Grenoble (FR); Blondeau, Beryl, 38700 La Tronche (FR)
(74) Representative: Grünecker, Kinkeldey, Stockmair & Schwanhäusser Anwaltssozietät

(57) **Abstract**

The invention concerns a method of preparation of a wafer (1), in particular a silicon on insulator (SOI) or silicon on quartz (SOQ) type wafer (7,15), designated to be used in the fabrication of devices for optical, electronic, opto-electronic or micro-mechanical applications, wherein the wafer comprises a front side (2) and a backside (3), and wherein functional structures (16) are created on or in at least the front side (2) of the wafer (1,7,15) during the fabrication process. In order to make wafer handling less critical and to obtain wafers with a good final product quality it is suggested to provide a cap layer on or in the backside of the wafer. Furthermore the invention also concerns a wafer (1), as described above, where a cap layer (4) is provided on or in the backside (3) surface of the wafer (1,7,15).

## Description

The invention concerns a wafer and the method of preparation of a wafer, in particular designated to be used in the fabrication of devices for optical, electronic, opto electronic or micro mechanical applications, according to the generic parts of claims 1 and 12, respectively.

Devices containing optical, electronic, opto electronic or micro mechanical applications are usually fabricated on wafers being made out of various materials like silicon, fused silica or gallium arsenide and can have different sizes and shapes. Usually functional, structures like transistors, are manufactured on the front side of the wafers. Due to the continuous shrinkage of the features sizes the surface quality and therein the front side as well as the back side quality are becoming more and more important in order to keep processing yields on an economical level. Furthermore new applications are created that use both sides of a wafer. Examples are micro mechanical (MEMS) devices or optical applications, like displays, where the functional structures are built on one side of a transparent wafer, transparent for visual light, and where the light leaves the device via the wafer.

Therefore wafer handling, which used to be performed by holding a wafer with an end effector on the backside of the wafer, is getting more and more critical and with the upcome of the 300mm wafers lead to complicated and expensive wafer handling system, preferably gripping the wafers at their rim side.

It is therefore the object of this invention to provide a wafer and a preparation method of wafers that makes wafer handling less critical and enables to obtain wafers with a good final product quality. This object is attained with a method according to claim 1.

The cap layer, applied to the backside during an additional process step, fulfils a protection against damage that could occur on the backside of the wafer, like for example mechanical or chemical damage. Thereto the cap layer sticks sufficiently well to the surface of the wafer and its physical and chemical characteristics are such that the integrity of the back side surface is ensured.

With the surface quality of the cap layer being by far not so important than the surface quality of the now underneath lying wafer backside, the wafer handling process becomes less critical and some state of the art wafer handling mechanisms can be applied with less risk. Also for devices where the backside plays a role, like in the given example of a display where light leaves the application via the backside of a transparent wafer, this process is advantageous as less scratches can be formed during the processing on the wafer backside, which is later on representing the interface of the device towards the environment. Therefore enhanced product quality and higher production yield can be obtained.

In a further embodiment of the invention an additional top layer, which can be one layer but also be composed out of several sub layers, is provided on or in the front side of the wafer. Examples for such wafers are silicon on insulator (SOl), silicon on quartz (SOQ) or similar wafers, which are getting more and more important. To achieve these wafers a number of additional process steps is necessary, each one with a certain risk of damaging or contaminating the backside of the wafer. Therefore in the inventive process, the cap layer is fabricated on or in the back side before the additional top layer is provided on or in the front side of the wafer. This ensures that the integrity of the wafer backside can be ensured against mechanical or chemical damage.

In a preferred embodiment of the invention the cap layer can be applied to the back side before any functional structure is created on the wafer or between two process steps leading to the creation of functional structures.

In a variant of the invention, the cap layer can be formed out of at least two sub layers, which are arranged in a sandwich-like manner. Therein sub layers can have various functions like, for example, in a display device one or several sub layers might fulfil the role of an antireflective coating. However at least one sub layer still plays the role of a protective layer against mechanical or chemical damage. This protective layer does not necessarily need to be the outermost sub layer.

In a further preferred embodiment of the invention the cap layer can be applied by means of deposition, in particular suitable are chemical vapour deposition (CVD), physical vapour deposition (PVD), plasma enhanced CVD (PECVD), low pressure CVD (LPCVD), sputtering or evaporation. With these methods the cap layer can be applied in an easy manner and with sufficient quality.

Another aspect of the inventive method can be to fabricate the cap layer with a sub layer having a minimum thickness of approximately 20 nm. Down to such a layer thickness sufficient protection is provided. In particular a sub layer with a thickness lying in a range of approximately 50 - 1000 nm is well suited. Besides providing the wished effect of protection to the back side surface of the wafer, such a layer can also be produced easily. In the case that the cap layer consists out of more than one sub layer, other sub layers can also have thicknesses according to the above mentioned minimum of approximately 20 nm and a particularly suitable range of 50 - 1000 nm.

A further preferred embodiment consists in choosing at least one sub layer of the cap layer as being made out of silicon dioxide, silicon nitride and/or diamond-like carbon (DLC). These layers can be easily applied in good quality and have sufficient protective effect.

In an advantageous manner at least one sub layer of the cap layer on the back side of the wafer can be removed before any functional structures are manufactured on or in the wafer. Thus in the case that the presence of this kind of layer harms the production process of the functional structures on or in the wafer the production process can be brought back to its well-known form.

In a further preferred embodiment it is foreseen that at least one sub layer of the cap layer on the back side of the wafer can be removed after functional structures have been manufactured on or in the front side of the wafer. This allows the back side of the wafer to be protected through the production process.

For the case that at least one sub layer of the cap layer on the back side of the wafer is removed, a preferred embodiment can be to use dry and/or wet etching and/or polishing, in particular chemical mechanical polishing (CMP) to remove cap layer material. Those removal processes can be easily applied to the present preparation method.

To further improve the quality of the removal step a further preferred embodiment can consist of applying an etch stop layer as an inner sub layer of the cap layer during the fabrication process of the cap layer. For the case that the material removal process is not element selective enough, due to the material characteristics of the protective layer and of the wafer, and that therefore the removal process can be a source of unwanted wafer backside damage, it is advantageous to apply the additional etch stop layer, which is sandwiched somewhere between the protective layer and the wafer. The physical and chemical properties of this layer are preferably chosen such as to allow the removal of the protective cap layer up until the etch stop layer.

The above-mentioned object is also attained by a wafer having the features of claim 12.

The applied cap layer protects the back side of the wafer against any mechanical or chemical damage and facilitates the handling of the wafer. Thereto the cap layer sticks sufficiently well to the surface of the wafer and its physical and chemical characteristics are such that the integrity of the back side surface is ensured.

With the surface quality of the cap layer being by far not so important than the surface quality of the now underneath lying wafer backside, the wafer handling process becomes less critical and state of the art wafer handling mechanisms can be applied with less risk. Also for devices where the backside plays a role, like in the given example of a display where light leaves the application via the backside of a transparent wafer, this process is advantageous as less scratches can be formed during the processing on the wafer backside, which is later on representing the interface of the device towards the environment. Therefore enhanced product quality and higher production yield can be obtained.

In a preferred embodiment the wafer is characterised in having a cap layer that comprises at least two sub layers. If necessary each cap layer can fulfill different roles. For example, the outermost layer could be chosen to be a protective layer against any mechanical or chemical damage and interior sub layers could form, for example in displays, an antireflective coating.

According to a variant of the invention the cap layer of the wafer has an inner sub layer which is acting as an etch stop layer. For the case that a material removal process is applied later to the wafer it could be that this material removal process is not element selective enough, due to the special material characteristic of the other sub layers and of the wafer itself, and that therefore the removal process could be a source of unwanted wafer back side damage. The physical and chemical properties of the etch stop layer are preferably chosen such as to allow that the removal of the protective cap layer will be up until the etch stop layer and that any deterioration of the back side of the wafer itself can be prevented.

In another preferred embodiment cap layer has a sub layer with a minimum thickness of approximately 20 nm. Down to such a layer thickness sufficient protection by the sub layer is provided. In particular a sub layer with a thickness lying in a range of approximately 50 - 1000 nm is well suited. Besides providing the wished effect of protection to the back side surface of the wafer, such a sub layer can also be produced easily. In the case that the cap layer consists out of more than one sub layer, other sub layers can also have thicknesses according to the above mentioned minimum of approximately 20 nm and a particularly suitable range of 50 - 1000 nm.

In another advantageous embodiment the wafer is characterised that at least one sub layer of the cap layer is made out of silicon dioxide, silicon nitride and/or diamond-like carbon (DLC). The characteristics of these materials are such that they can provide the desired protective role.

The invention also encompasses a wafer comprising functional structures for optical, electronic, opto electronic or micro mechanical applications, according to at least one of claims 12 to 16.

In the following preferred embodiments of the inventive wafer and the inventive preparation method are described with respect to the Figures, in which
- Fig. 1: shows a perspective view of a wafer according to a first embodiment with a cross-section perpendicular to the front side of the wafer;
- Fig. 2: shows a perspective view of a wafer according to a second embodiment with a cross-section perpendicular to the wafer front side of a silicon on insulator (SOl) wafer or silicon on quartz (SOQ) wafer;
- Fig. 3: shows a perspective view of a wafer according to a third embodiment with a cross-section perpendicular to the front side of a SOl or SOQ wafer; and
- Fig. 4: shows an inventive preparation process diagram of a SOl or SOQ wafer.

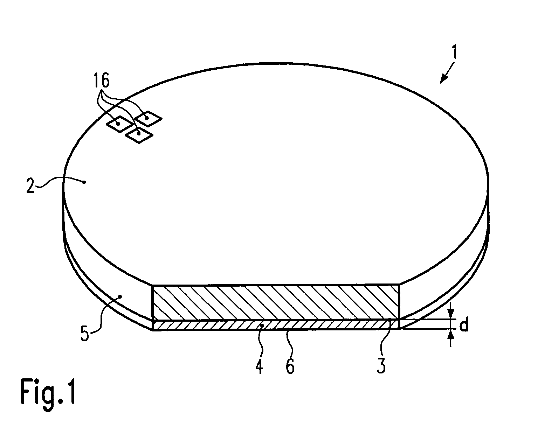

In Fig. 1, reference 1 shows a wafer according to the first embodiment, designated to be used in the fabrication of devices for optical, electronic, opto electronic or micro mechanical applications with a front side 2 and a back side 3. On the back side 3 of the wafer 1 a cap layer 4 is applied, providing protection against back side damage. Usually the wafer 1 has a disk-like shape, but also rectangular or square formats are available. Disk-like wafers 1 usually have diameters of up to 300 mm, but in the future even bigger diameters are foreseen. In most applications the front side 2 is polished, however in further applications both sides of the wafer 1 might need to be polished. Typical wafer materials include silicon, gallium arsenide (GaAs), germanium (Ge), indium phosphide (InP), gallium nitride (GaN), fused silica or quartz, with the list not being exclusive.

Fig. 1 shows that the cap layer 4 is covering the whole back side 3 of the wafer 1. Furthermore it is also possible to extend the cap layer onto the wafer side walls 5. Typical suitable materials for the cap layer 4 are, for example, silicon dioxide, silicon nitride or diamond-like carbon. The minimum thickness d of the cap layer 4 is approximately 20 nm, but preferably the thickness should be in a range of 50 - 1000 nm. Depending on the further use of the wafer 1, the surface 6 of the cap layer 4 can either be polished or not.

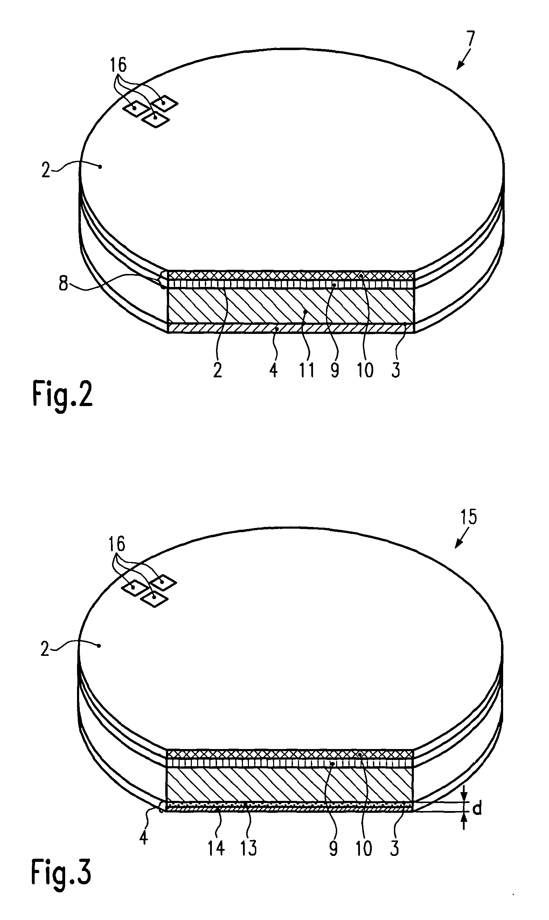

According to the second embodiment of the invention, Fig. 2 shows an SOl or SOQ wafer with reference 7. Compared to the wafer 1 shown in Fig. 1 this kind of wafer is characterised in having a top layer structure 8 on top of the wafer front side 2. In an SOl wafer 7 this top layer 8 is made out of at least two top sub layers 9 and 10. Top sub layer 9 which is on top of the wafer front side 2 is preferably an insulator like, for example, silicon dioxide. The second top sub layer 10 is preferably a semiconductor material like silicon. The wafer material 11 of an SOl wafer can be silicon and for a so-called SOQ wafer the wafer material 11 can be fused silica. Like for the wafer 1 of Fig. 1 the back side 3 of the wafer 7 is covered by the cap layer 4, which fulfils the role of the protective layer. All above-mentioned characteristics of the cap layer 4 are also valid for this kind of wafer 7.

Fig. 3 shows the third embodiment of the invention. Compared to the SOl wafer of this SOl wafer 15 has a cap layer 4 which is formed out of two sub layers. In this example the first sub layer 13, which is applied directly on the back side 3 of the wafer 15, is an etch stop layer. The second sub layer 14 represents the layer providing the protection. Like for wafer 7, shown in Fig. 2, the wafer front side 2 is covered by a top layer 8 made out of two top sub layers 9 and 10, having the same material characteristics as the two top sub layers described previously.

In this example the outermost sub layer 14 of the cap layer 4 is silicon dioxide which is providing the protection against mechanical and chemical damage and the inner sub layer 13 is made out of silicon nitride. Furthermore it should be mentioned that other material combinations are also possible and known to the specialist.

The advantage to put more than one sub layer on the back side 3 of the wafer 15 is that it allows selective etching. Different methods are available to eliminate the different sub layers like, for example, dry or wet etching and polishing or touch polishing. The final goal of the choice of the sub layer materials is that after removing the sub layers, by said different methods, the back side 3 of the wafer 15 presents no defects. Thus in the multiple sub layer structure the material of the sub layer 14 can be chosen to be such that it is a well functioning protective layer without having to be concerned that it can be removed without damaging the back side 3 of the wafer 15 and the material of sub layer 13 can be chosen such to be directly on the surface of the back side 3 of the wafer 15 and to have such characteristics that a removal is possible without damaging the back side 3.

The cap layer of the first and second embodiment can also have a multilayer structure as in the third embodiment.

All three embodiments can have as an alternative already functional structures 16 provided on at least the front side 2. Those functional structures 16 can be for example transistors, electrodes, insulators, but also coatings, mirrors or micro mechanical structures. Those structures 16 need not necessarily to be provided on or in the whole surface 2 of the wafer 1, 7 or 15.

In a further variant of the previous embodiments the cap layer 4 on the backside 3 of the wafers 1, 7, 15 can only partially cover the backside 3. For example only at places that are later on touched by the wafer handling system or only those areas of the wafer where the backside is going to be important for the final product.

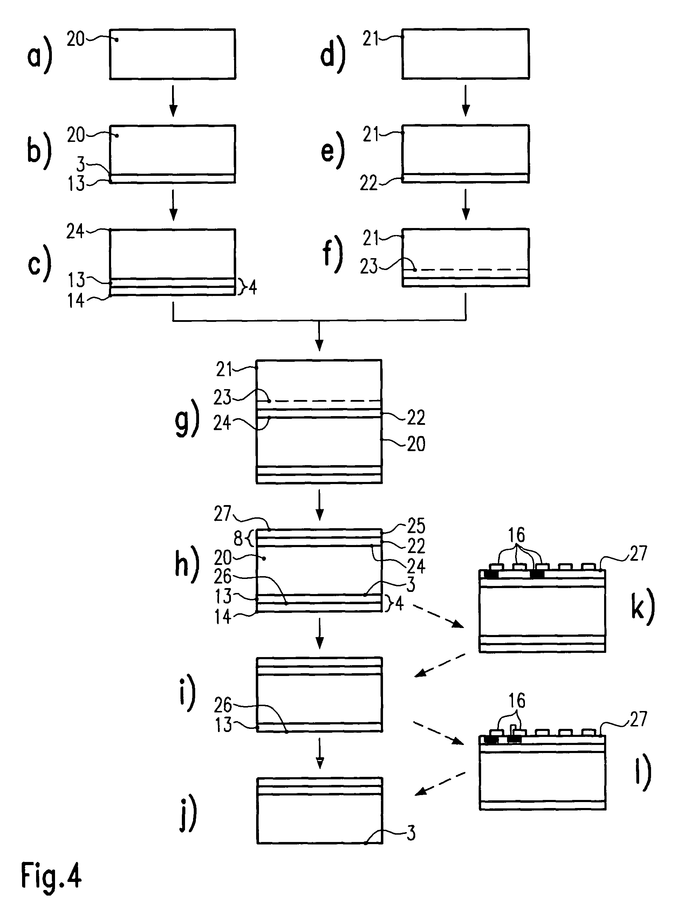

Fig. 4 shows the manufacturing process of an SOl or SOQ-type wafer 7 and 15 of the Figs. 1 and 2, wherein the back side 3 of the wafer is covered by the cap layer 4.

Several processes to obtain SOl or SOQ-type wafers are known in the prior art. Here we schematically show the smart cut process, but emphasis is only put on the process steps providing the cap layer 4 on the back side 3 of the wafer.

Step 4a shows a wafer 20, which has the same properties like the wafer described earlier in the description of Fig. 1. In the smart cut process this wafer is called base wafer 20.

In a next process step 4b a first sub layer 13 is deposited on the back side 3 of the base wafer 20. This first sub layer can be made out of silicon (SiO₂) like in the earlier mentioned embodiments, however other types of layers can also be deposited. In principal the sub layer 13 can be deposited by any suitable deposition method, in particular suitable are plasma enhanced chemical vapor deposition (PECVD),low pressure chemical vapor deposition (LPCVD) or sputtering. PECVD is, for example, performed in a reactor at temperatures up to 400°C and at pressures of about 2.5 Torr. The deposited film is a product of a chemical reaction between SiH4 and N20. The plasma is generated by radio frequency with a power of about 200W to increase the available energy for the reaction. A possible frequency for this equipment is 13,56 MHz. The film is usually deposited in a few seconds. The layer is preferably fabricated with a minimum thickness of approximately 20nm, but in particular with a thickness in a range of approximately 50 - 1000 nm. The LPCVD is applied on two sides and the PECVD is applied on one side of the wafer.

Following the first sub layer deposition step, a second sub layer 14 is deposited onto the first sub layer 13, which is shown in step 4c. This second layer 14 can be a silicon nitride layer (Si₃N₄), but other materials are also suitable. The sub layer can be deposited by any suitable deposition method, in particular PECVD and LPCVD like the first cap layer. For PECVD the process parameters for the Si02 layer are approximately: reactor temperature of up to 400°C, pressure of about 5 Torr, RF power supplied of about 625W and the reactive gases are SiH4, N2 and NH3. Similar to the Si3N4 layer the Si02 layer is deposited in a few seconds. Again the layer is preferably fabricated with a minimum thickness of approximately 20nm, but in particular with a thickness in a range of approximately 50 - 1000 nm. As can be seen in step 4c, the second sub layer 14 is covering the whole surface of the first sub layer 13, which leads to a sandwich-like structure.

Step 4d shows a second wafer which in the smart cut process is called top wafer 21, also having the same properties as described earlier in the description of figure 1. In a process step the top wafer 21 gets oxidised, the result of which can be seen in step 4e. Due to the oxidation process at least on one side of the wafer 21 an oxide layer 22 is formed. In a following process step 4f hydrogen 23 gets implanted into the top wafer 21.

Process steps 4e and 4f can be performed in parallel to the steps 4b and 4c.

In a following process step the top wafer 21 and the base wafer 20 are bonded together, with the result shown in step 4g. During the bonding process the oxide layer 22 of the top wafer 21 is brought into contact with the front side of the base wafer 24.

In a following process step the upper part of the top wafer 21, wherein upper means above the hydrogen line 23 away from the oxide layer 22, is split off from the bonded wafers, according to the smart cut process. The result of this process step is shown as step 4h. The wafer is now characterised in having a cap layer 4 on the base wafer back side 3 and by having a top layer 8 on the front side 24 of the former base wafer 20. Therein the top layer 8 is made out of the two top sub layers 22, 25 wherein the first top sub layer 22 represents the oxide layer and the second top sub layer 25 represents the semiconductor layer. The cap layer 4 has the two sub layers 13, 14, reference 26 depicts the interface between the two sub layers.

In a subsequent, optional, process step the first sub layer 14 is removed from the cap layer structure 4. The result of which can be seen in Fig. 4i. The removal method is chosen to be such that the removal process stops at the interface 26 to the second sub layer 13 of the cap layer 4. This is achieved by element selective removal methods like, for example wet etch, dry etch or chemical mechanical polishing. In this example, where the to be removed layer is preferably made out of silicon dioxide, a suitable removal method is wet etch with hydrofluoric acid (HF) or dry etch like reactive ion etching plasma (RIE), direct current (DC) or radio frequency (RF) sputtering or inductively coupled plasma (ICP), which are typically using CF4, C2F6 or CHF3, but also CMP using oxide pads can be used. These removal methods have a high removal rate, which is the amount of material removed per time unit, for Si02 and have a slower removal rate for the subsequent layer, which is preferably Si3N4. Thus the removal process can be easily controlled to stop at the interface 26.

In a following, optional, process step 4j also the first sub layer 13 of the cap layer 4 is removed. In the case this sub layer 13 is made out of Si3N4 an example for a suitable removal method is wet etch with concentrated hot orthophosphoric acid (H3PO4). The result of this process step can be seen in step 4j, where the SOl or SOQ wafer is shown, of which the back side 3 has been protected during the whole SOl or SOQ fabricating process.

Further optional process steps 4k, 4l can be performed between steps 4h and 4i and/or between 4i and 4j wherein functional structures 16 are manufactured on or in the front side 27 of the SOl or SOQ wafer. Those functional structures 16 can be for example transistors, electrodes, insulators, but also coatings, mirrors or micro mechanical structures. Functional layers 16 can of course also be manufactured after process step 4i, which is not shown in Figure 4.

In general it has to be understood that in this application the cap layers mentioned throughout the application are all artificial layers applied on the wafers.

The above described process could for example be used to manufacture a display device. In such a device use is made of a SOQ wafer 15, where the front side 27 contains the necessary electronic functional structures 16 like transistors, electrodes, signal lines and where light created in those structures travels through the wafer 15 to leave the wafer at the backside 3 towards the environment. As the backside 3 was protected during the whole or at least a part of the production process the presence of scratches, that would deviate or scatter the light and therefore lower the display quality, is greatly reduced. Other examples where the inventive method or the inventive wafer could be used include sensors, where the light enters the device via the quartz or light emitting diodes.

## Claims

1. Method of preparation of a wafer (1), in particular a silicon on insulator (SOl) or silicon on quartz (SOQ) type wafer (7,15), designated to be used in the fabrication of devices for optical, electronic, opto-electronic or micro-mechanical applications, wherein the wafer comprises a front side (2) and a backside (3), and wherein functional structures (16) are created on or in at least the front side (2) of the wafer (1,7,15) during the fabrication process,
**characterised in that** a cap layer (4) is applied on or in the backside (3) surface of the wafer (1,7,15).

2. The wafer preparation method according to claim 1, wherein an additional top layer (8) is provided on or in the front side (3) of the wafer (1,7,15),
**characterised in that** the cap layer (4) is applied to the backside (3) of the wafer before the top layer (8) is provided on or in the front side (2) of the wafer.

3. The method according to claim 1 or 2,
**characterised in that** the cap layer (4) is applied before any functional structure (16) is created on the wafer or between two process steps leading to the creation of functional structures (16).

4. The method according to at least one of claims 1 to 3,
**characterised in that** the cap layer (4) is formed out of at least two sub layers (13,14) arranged in a sandwich-like manner.

5. The method according to at least one of claims 1 to 4,
**characterised in that** the cap layer (4) is applied by deposition, in particular chemical vapor deposition (CVD), physical vapor deposition (PVD), plasma enhanced CVD, low pressure CVD, sputtering and/or evaporation.

6. The method according to at least one of claims 1 to 5,
**characterised in that** the cap layer (4) is fabricated with a sub layer (4,14) having a minimum thickness of approximately 20 nm, in particular a thickness in a range of approximately 50-1000 nm.

7. The method according to at least one of claims 1 to 6,
**characterised in that** at least one sub layer (13,14) of the cap layer (4) is made out of Si02, Si3N4 and/or diamond like carbon (DLC).

8. The method according to at least one of claims 1, 2, 4 to 8,
**characterised in that** at least one sub layer (14) of the cap layer (4) on the backside (3) of the wafer is removed before any functional structures (16) are manufactured on or in the wafer.

9. The method according to at least one of claims 1 to 7,
**characterised in that** at least one sub layer (14) of the cap layer (4) on the backside (3) of the wafer is removed after functional structures (16) have been manufactured on or in the front side (2) of the wafer.

10. The method according to claims 9 or 10,
**characterised in that** at least one sub layer (14) of the cap layer (4) on the backside (3) of the wafer is removed by dry and/or wet etching and/or polishing, in particular chemical mechanical polishing (CMP).

11. The method according to at least one of claims 1-10,
**characterised in that** an etch stop layer (13) is applied as an inner sub layer of the cap layer (4).

12. A wafer (1), in particular a silicon on insulator (SOl) or silicon on quartz (SOQ) type wafer (7,15), designated to be used in the fabrication of devices for optical, electronic, opto-electronic or micro-mechanical applications, wherein the wafer (1,7,15) comprises a front side (2) and a backside (3), and at least the front side (2) is prepared to be provided with functional structures (16) in a subsequent fabrication,
**characterised in that** a cap layer (4) is provided on or in the backside (3) surface of the wafer (1,7,15).

13. The wafer according to claim 12,
**characterised in that** the cap layer (4) comprises at least two sub layers (13,14).

14. The wafer according to claim 13,
**characterised in that** the cap layer (4) has an inner sub layer acting as an etch stop layer (13).

15. The wafer according to at least one of claims 12 to 14,
**characterised in that** the cap layer (4) has a sub layer (14) having a minimum thickness of approximately 20 nm, in particular a thickness in a range of approximately 50-1000 nm.

16. The wafer according to at least one of claims 12 to 16,
**characterised in that** at least one sub layer (13,14) of the cap layer (4) is made out of Si02, Si3N4 and/or diamond like carbon (DLC).

17. A wafer (1,7,15) comprising functional structures (16) for optical, electronic, opto-electronic or micro-mechanical applications, according to at least one of the claims 12-16.
